(19) Europäisches Patentamt
European Patent Office
Office européen des brevets

(11) **EP 2 601 491 B1**

(12) **FASCICULE DE BREVET EUROPEEN**

(45) Date de publication et mention de la délivrance du brevet:
**10.10.2018 Bulletin 2018/41**

(51) Int Cl.:
***G01L 1/22*** *(2006.01)*     ***G06F 3/041*** *(2006.01)*
***G01L 1/14*** *(2006.01)*

(21) Numéro de dépôt: **11751560.1**

(22) Date de dépôt: **01.08.2011**

(86) Numéro de dépôt international:
**PCT/EP2011/063205**

(87) Numéro de publication internationale:
**WO 2012/016945 (09.02.2012 Gazette 2012/06)**

(54) **SURFACE TACTILE ET PROCÉDÉ DE FABRICATION D'UNE TELLE SURFACE**

TAKTILE OBERFLÄCHE UND VERFAHREN ZUR HERSTELLUNG EINER DERARTIGEN OBERFLÄCHE

TACTILE SURFACE AND METHOD OF MANUFACTURING SUCH A SURFACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.08.2010 FR 1056387**

(43) Date de publication de la demande:
**12.06.2013 Bulletin 2013/24**

(73) Titulaires:
- **Nanomade Concept**
  **31100 Toulouse (FR)**
- **Institut National des Sciences Appliquées de Toulouse**
  **31400 Toulouse (FR)**
- **Centre National de la Recherche Scientifique**
  **75016 Paris (FR)**

(72) Inventeurs:
- **VIALLET, Benoît**
  **F-31400 Toulouse (FR)**
- **RESSIER, Laurence**
  **F-31520 Toulouse (FR)**
- **GRISOLIA, Jérémie**
  **F-31840 Aussonne (FR)**
- **SONGEON, Lionel**
  **F-31170 Tournefeuille (FR)**
- **MOUCHEL LA FOSSE, Eric**
  **F-31170 Tournefeuille (FR)**
- **CZORNOMAZ, Lukas**
  **F-31400 Toulouse (FR)**

(74) Mandataire: **Ipside**
**29, rue de Lisbonne**
**75008 Paris (FR)**

(56) Documents cités:
**EP-A2- 2 053 495**     **WO-A1-03/018307**
**US-A1- 2008 238 882**     **US-A1- 2009 278 815**

- **HERRMANN J ET AL: "Nanoparticle films as sensitive strain gauges", APPLIED PHYSICS LETTERS, AIP, AMERICAN INSTITUTE OF PHYSICS, MELVILLE, NY, US, vol. 91, no. 18, 30 octobre 2007 (2007-10-30), pages 183105-183105, XP012099977, ISSN: 0003-6951, DOI: DOI:10.1063/1.2805026**

## Description

L'invention appartient au domaine des surfaces tactiles et concerne une telle surface, son procédé de réalisation et son utilisation pour détecter et mesurer des efforts appliqués sur une telle surface. Ce type de surface est utilisé, par exemple, dans de nombreuses applications électroniques grand public, notamment informatiques, sous différentes formes, dites « *touch pad »,* « écran tactile », « *write pad* » etc.

Dans ces exemples de l'art antérieur, les surfaces tactiles sont configurées de sorte à détecter un ou plusieurs contacts qui peuvent être digitaux ou par l'intermédiaire d'un accessoire tel un stylet. Lorsqu'elles comprennent une pluralité de capteurs disposés selon une organisation matricielle, elles permettent de suivre le déplacement desdits points de contact.

Les surfaces de l'art antérieur sont rendues fonctionnelles, ou fonctionnalisées, par l'intermédiaire de capteurs qui mesurent la variation d'une propriété physique lors d'un contact digital ou d'un accessoire sur la surface tactile.

Les principales propriétés physiques mesurées, selon l'art antérieur, sont, la résistivité ou la résistance électrique et la variation de capacité électrique. Il existe également des technologies basées sur l'émission d'ultrasons ou de rayons infrarouges.

Les surfaces tactiles de l'art antérieur permettent essentiellement de détecter le contact, mais ne permettent pas de quantifier celui-ci. Par quantifier, on entend déterminer la pression ou la force résultante de contact, la direction de cette force résultante lorsque celle-ci comporte des composantes autres que normales à la surface tactile, et les coordonnées du point d'application de cette force dans un repère lié à la surface tactile, les forces de contact appliquées à une telle surface tactile étant essentiellement normales à ladite surface. Selon certains modes de réalisation de l'art antérieur, ledit contact doit être appliqué avec une force suffisante pour être détecté, par exemple dans le cas d'une mesure de résistivité ou de résistance, mais ne donne pas d'information sur l'intensité de l'effort de contact avec la surface. Un exemple de ce mode de réalisation est décrit dans le document US 2008/238882.

Pour certaines applications il peut être cependant utile d'avoir des informations sur l'intensité de cet effort, ou sur la pression de contact exercée, sur les points d'application de la force, notamment lorsque l'on souhaite que la surface tactile soit apte à détecter plusieurs points ou zones de contact, notamment simultanés, et finalement sur la direction de la force appliquée.

L'invention vise à créer des surfaces tactiles dont la réponse permet de quantifier le système d'efforts de contact qui leur est appliqué.

La technologie connue de l'art antérieur permettant de répondre à ce besoin consiste à réaliser un corps d'épreuve, c'est-à-dire, un solide déformable dont on connaît ou dont on peut calculer par méthode directe les modes de déformation sous l'effet d'un système de chargement, ledit corps d'épreuve étant déformé sous l'action des efforts qui lui sont appliqués. Il suffit alors de mesurer sa déformation pour connaître, par méthode inverse, le système de chargement auquel il est soumis. La déformation du corps d'épreuve est mesurée le plus souvent par des jauges de déformation, qui délivrent une variation d'une propriété électrique proportionnelle à leur allongement. La difficulté de cette méthode réside cependant en plusieurs points. Tout d'abord, pour que cette méthode soit efficace, la forme du corps d'épreuve doit être simple et ses conditions de support maîtrisées. À titre d'exemple, s'il est assez facile de déterminer par méthode inverse le mode de chargement d'un corps d'épreuve plan de faible épaisseur maintenu sur sa périphérie dès lors que les efforts normaux à ce plan sont appliqués en des points suffisamment éloignés des bords, il devient nettement plus compliqué d'appliquer une telle méthode si la surface du corps d'épreuve est courbe ou si elle est maintenue de manière plus complexe.

De plus, il faut que le corps d'épreuve soit suffisamment déformable pour que la mesure de sa déformation par des jauges soit possible. Or, dans de nombreuses applications citées plus haut, il est souhaité une surface tactile rigide. Il faut alors utiliser des jauges de déformations particulièrement sensibles. Le brevet US 7 116 209 décrit des jauges de déformation particulièrement sensibles, adaptées à une mesure de déformation dite longitudinale, c'est-à-dire tangentiellement à la surface sur laquelle elles sont collées. Ces jauges de l'art antérieur reposent, dans leur principe de mesure, sur la variation de la résistivité d'une assemblée de nanoparticules conductrices lorsque la distance entre lesdites particules est modifiée sous l'effet de la déformation du corps d'épreuve sur lequel lesdites jauges sont collées. De telles jauges peuvent être mises en réseau pour mesurer de manière fidèle la déformation d'un corps d'épreuve en réponse à divers systèmes de chargement. Toutefois, ce principe souffre des mêmes limitations que les autres technologies de l'art antérieur, à savoir que la fonction tactile, c'est-à-dire la capacité de mesure d'une action essentiellement normale à la surface, est tributaire des conditions aux limites, de la forme du corps d'épreuve et de la capacité à évaluer la sollicitation de celui-ci par méthode inverse, les jauges mesurant les déformations tangentiellement à la surface fonctionnalisée.

WO03018307 divulgue une jauge de déformation particulièrement sensible.

US2009/278815 décrit une surface tactile comprenant deux électrodes séparées par un milieu élastique comprenant des particules conductrices. Les dites particules électriquement conductrices sont dispersées dans le milieu électriquement isolant Pour résoudre ces inconvénients de l'art antérieur, l'invention propose un dispositif pour la détection et la quantification d'une force appliquée sur une surface dite tactile comprenant :

- un corps d'épreuve ;
- un substrat électriquement isolant ;
- une première électrode liée au substrat et fixe par rapport audit substrat ;
- une seconde électrode ;
- une assemblée de nanoparticules conductrices ou semi-conductrices en contact avec les deux électrodes ;
- un dispositif de mesure délivrant une information proportionnelle à une propriété électrique de l'assemblée de nanoparticules, laquelle propriété est mesurée entre la première et la seconde électrode, ladite propriété électrique étant proportionnelle à une variation de distance entre les nanoparticules de l'assemblée ;

tel que le corps d'épreuve consiste en l'assemblée de nanoparticules.

Ainsi, la présente invention utilise directement l'assemblée de nanoparticules comme corps d'épreuve et permet la quantification d'un effort, essentiellement normal à ladite assemblée, même si celle-ci est déposée sur une surface rigide. Le substrat peut être rigide ou présenter une certaine compressibilité, et les déformations de l'assemblée de nanoparticules peuvent être découplées de celles de la surface fonctionnalisée par ce dispositif. Ainsi contrairement à l'art antérieur où le substrat et son mode de fixation sur le corps d'épreuve doivent assurer un couplage parfait entre les déformations du corps d'épreuve et l'assemblée de nanoparticules, le dispositif objet de l'invention s'affranchit de cette contrainte et offre plus de souplesse de réalisation dans la forme et la nature des surfaces tactiles.

Une « assemblée de nanoparticules », est constituée d'un ou plusieurs ensembles de nanoparticules liées entre elles par un ligand au sein de chaque ensemble, lesdits ensembles étant liés entre eux électriquement.

Par « information proportionnelle » on entend une mesure qui varie avec la propriété mesurée, la fonction de proportionnalité pouvant être linéaire, exponentielle ou de toute autre forme mathématique établissant une relation univoque entre la valeur de la mesure et la valeur de la propriété mesurée.

L'invention peut être mise en oeuvre selon les modes réalisation avantageux exposés ci-après, lesquels peuvent être considérés individuellement ou selon toute combinaison techniquement opérante.

Selon une première configuration de réalisation, la seconde électrode est distante de la première et mobile par rapport au substrat et l'assemblée de nanoparticules se trouve entre les deux électrodes de telle sorte qu'un déplacement de la seconde électrode provoque une modification de la distance entre les nanoparticules de ladite assemblée. Cette configuration permet de créer un capteur de force élémentaire apte à mesurer l'effort auquel il est soumis en chacune de ses extrémités, c'est-à-dire sur chacune de ses électrodes. On entend par « une électrode mobile par rapport au substrat», une l'électrode placée de telle sorte qu'un déplacement de celle-ci modifie la distance relative entre cette électrode et le substrat provoquant ainsi une modification de la distance entre les nanoparticules. Ce déplacement est en réalité un microdéplacement auquel s'oppose une force de rappel fonction de la raideur de l'assemblée de nanoparticules et du substrat.

Avantageusement, quelle que soit la configuration de réalisation, la propriété électrique mesurée est la résistance de l'assemblée de nanoparticules. Cette propriété électrique est particulièrement facile à mesurer.

Alternativement, la propriété électrique mesurée est la capacité électrique de l'assemblée de nanoparticules. Cette propriété électrique offre l'avantage de pouvoir être mesurée à distance, sans contact, dans toutes les configurations de réalisation.

Selon un perfectionnement de la première configuration de réalisation,

- la première électrode consiste en une pluralité de bandes conductrices parallèles s'étendant sur la surface du substrat dans une première direction ;

- la seconde électrode consiste en une pluralité de bandes conductrices parallèles dans une seconde direction différente de la première ;

- l'assemblée de nanoparticules étant structurée topographiquement en une pluralité d'amas discrets se trouvant entre les deux électrodes aux emplacements de croisement des directions des bandes conductrices de la première et de la deuxième électrode.

Ainsi la surface tactile est rendue fonctionnelle par un réseau matriciel de capteurs de force élémentaires, et offre la possibilité de déterminer les points d'application des efforts sollicitant ladite surface ainsi que l'intensité desdits efforts.

Selon une deuxième configuration de réalisation, l'assemblée de nanoparticules est placée sur le substrat dont elle recouvre une partie de la surface et les électrodes consistent en des bandes conductrices liées au substrat et s'étendant entre une partie de la surface dudit substrat non couverte par l'assemblée de nanoparticules et le pourtour de la surface couverte par les nanoparticules. Cette configuration permet de fonctionnaliser la surface tactile de manière spatialement continue.

Selon une troisième configuration de réalisation, l'assemblée de nanoparticules est placée sur le substrat dont elle recouvre une partie de la surface, la première électrode consiste en des bandes conductrices liées au substrat et s'étendant entre une partie de la surface dudit substrat non couverte par l'assemblée de nanoparticules et le pourtour de la surface couverte par les nanoparticules et la seconde électrode mobile par rapport au substrat, se trouvant sur l'assemblée de nanoparticules. Cette configuration permet de quantifier l'effort appliqué sur la seconde électrode agissant sur l'assemblée de nanoparticules, en intensité et en orientation.

Selon une première variante des deuxièmes et troisièmes configurations de réalisation, l'assemblée de nanoparticules comprend plusieurs couches superposées de nanoparticules selon une direction sensiblement normale au substrat.

Selon une seconde variante de ces mêmes configurations de réalisation, l'assemblée de nanoparticules s'étendant à la surface du substrat est monocouche, ledit substrat étant compressible vis-à-vis des sollicitations normales de sorte qu'une pression localisée normale au substrat produise une modification de la distance entre les nanoparticules de ladite assemblée.

L'invention concerne également un procédé pour la fabrication d'une surface tactile selon la première configuration de réalisation, ledit procédé comprenant les étapes consistant à :

- déposer sur un substrat isolant un premier réseau de bandes conductrices parallèles s'étendant selon une première direction ;

- déposer sur ces bandes des amas de nanoparticules lesquels amas comprennent au moins deux couches de nanoparticules superposées dans une direction normale à la surface, les amas étant séparés les uns des autres et disposés selon un motif répétitif dans une direction parallèle à la direction des bandes ;

- déposer sur l'ensemble un second réseau de bandes conductrices parallèles s'étendant selon une seconde direction différente de la première et contactant les amas de nanoparticules.

Ainsi, une telle surface peut être préparée par des procédés connus notamment par photolithographie ou par nano-impression pour le dépôt des électrodes et par dépôt convectif capillaire ou par nano-xérographie pour les amas de nanoparticules.

Selon un mode de réalisation particulier de ce procédé, l'étape de dépôt des amas de nanoparticules selon un motif répétitif comprend des étapes consistant à :

- déposer sur l'ensemble substrat et premier réseau de bandes conductrices une couche isolante comprenant des trous débouchant sur lesdites bandes ;

- déposer dans les trous de la couche isolante des amas de nanoparticules comprenant au moins deux couches superposées dans une direction sensiblement normale au substrat et contactant les bandes conductrices sous jacentes ;

- déposer sur l'ensemble un second réseau de bandes conductrices parallèles s'étendant selon une seconde direction différente de la première et contactant les amas de nanoparticules.

Ce mode de réalisation du procédé peut être mis en oeuvre avec les mêmes moyens et présente une fiabilité de réalisation accrue.

Avantageusement, lorsque la propriété électrique mesurée est proportionnelle à la capacité de l'assemblée de nanoparticules, le dispositif de mesure comprend un circuit résonnant couplant en parallèle l'assemblée de nanoparticules et une inductance accordée. Ainsi est-il possible d'effectuer une mesure à distance et sans contact en excitant ledit circuit par une excitation électromagnétique.

À cette fin l'invention concerne également un procédé pour la mesure d'une force appliquée sur un tel dispositif selon ce dernier mode de réalisation, ledit procédé comprenant les étapes consistant à :

- soumettre le circuit résonnant à une excitation électromagnétique ;

- mesurer la variation d'absorption dudit circuit lorsque l'assemblée de nanoparticules est soumise à ladite force.

Ce procédé permet d'utiliser la variation de capacité électrique de l'assemblée de nanoparticules comme propriété proportionnelle à l'effort appliqué sur la surface tactile, laquelle capacité est mesurée sans contact et à distance.

Selon une première variante de ce procédé, l'excitation électromagnétique est réalisée à une fréquence d'excitation continue et la variation mesurée est le déplacement en fréquence du spectre d'absorption du circuit. Avantageusement, l'excitation est réalisée à la fréquence de résonance du circuit et la variation mesurée est le déplacement de cette fréquence de résonance.

Selon une deuxième variante de ce procédé, l'excitation électromagnétique est réalisée à une fréquence puisée, et la variation mesurée est l'émission du circuit résonnant durant les phases de relaxation.

Avantageusement, le circuit résonant comprend des moyens émettant un code d'identification unique lorsque ledit circuit est soumis à une excitation électromagnétique.

L'invention concerne également une surface tactile comprenant le dispositif objet de l'invention selon l'un quelconque de ses modes de réalisation.

L'invention sera maintenant plus précisément décrite dans le cadre de modes de réalisation préférés, nullement limitatifs, et des figures 1 à 8, dans lesquelles :

- la figure 1 représente en perspective un schéma de principe d'un premier mode de réalisation d'un capteur de force élémentaire ;
- la figure 2 représente en perspective un synoptique d'un mode de réalisation du procédé de fabrication d'une surface tactile constituée d'un réseau matriciel de capteurs de force élémentaires ;

- la figure 3 montre en perspective un exemple de réalisation d'une surface tactile comprenant une assemblée de nanoparticules, les électrodes de mesure étant placées sur le pourtour de cette assemblée de nanoparticules
- la figure 4 illustre dans le principe, selon une vue en perspective, la réponse d'une assemblée de nanoparticules semblable à celle de la figure 3 soumise à un système de force ;
- la figure 5 montre, selon une vue de dessus en perspective un exemple de réalisation d'un capteur d'effort comprenant une assemblée de nanoparticules et un ensemble de premières électrodes réparties sur le pourtour de l'assemblée de nanoparticules, une seconde électrode étant placée sur l'assemblée de nanoparticules ;
- la figure 6 montre en vue de dessus et en perspective une autre variante de réalisation du dispositif objet de l'invention utilisant une assemblée de nanoparticules, les électrodes étant placées sur le pourtour de l'assemblée, l'une des électrodes étant réalisée par une pluralité de bandes ;
- la figure 7 est un schéma de principe d'un dispositif selon un mode de réalisation de l'invention utilisant la capacité électrique comme propriété sensible à la distance entre les nanoparticules de l'assemblée ;
- et la figure 8 illustre selon une vue en coupe et de face les modes de déformation de l'assemblée de nanoparticules du dispositif objet de l'invention placé sur une surface fonctionnalisée dite tactile, ladite assemblée étant monocouche (figures 8B et 8E) ou multicouches (figures 8A, 8C et 8D) laquelle assemblée étant déposée sur un substrat rigide (figure 8C) ou sur un substrat compressible (figures 8D et 8E).

Toutes ces figures ont pour but de représenter de manière compréhensible les caractéristiques structurelles du dispositif selon ses différents modes de réalisation et ne sont en aucun cas représentatives des dimensions ou de l'échelle des différents composants.

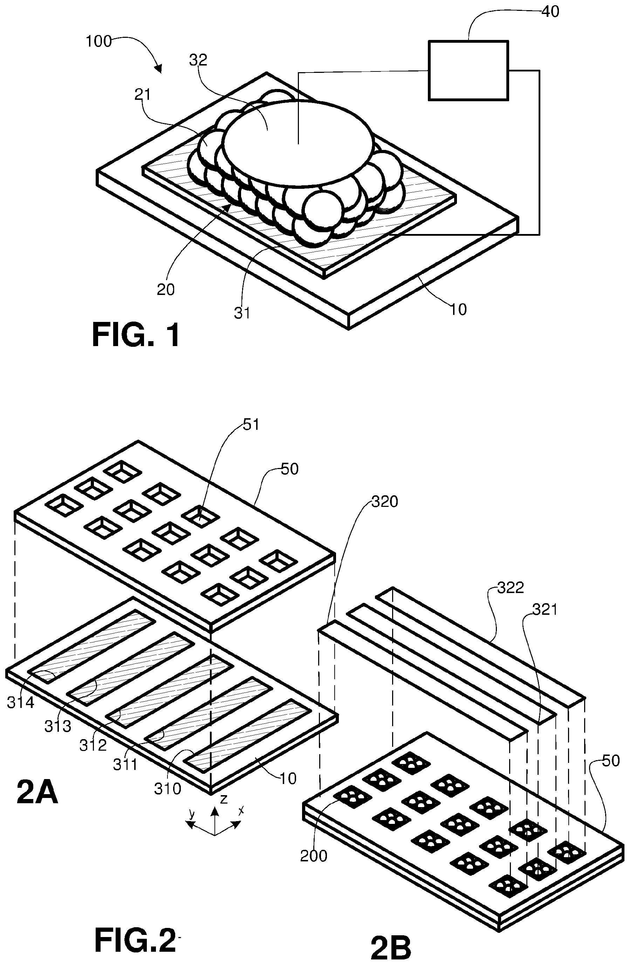

Figure 1, selon un premier exemple de réalisation d'un dispositif selon l'invention comprenant une assemblée de nanoparticules constituée de plusieurs couches superposées, ledit dispositif comprend un substrat (10) électriquement isolant, auquel est liée une première électrode (31), de sorte que cette première électrode soit fixe par rapport audit substrat. Des moyens de mesure (40) permettent de mesurer la variation d'une propriété électrique entre cette première électrode (31) et une seconde électrode (32) placée dans un plan distant sensiblement parallèle au substrat (10). Une assemblée de nanoparticules (20) est placée entre les deux électrodes (31, 32). Cette assemblée comprend une pluralité de nanoparticules (21) électriquement conductrices ou semi-conductrices, organisées en plusieurs couches, lesdites nanoparticules étant liées entre elles par un ligand électriquement résistant. Ce ligand est avantageusement choisi parmi des composés comprenant des fonctions aptes à se lier chimiquement avec les nanoparticules. À titre d'exemple non limitatif il peut s'agir de fonctions citrate, amine, phosphine ou thiol. À titre d'exemple :

- le citrate de sodium : $C_6H_5O_7^{3-}$, $3Na^+$ pour un composé comprenant une fonction citrate ;
- le bis-p-sulfonatophenyl phenylphosphine dihydrate de sodium, pour un composé comprenant une fonction phosphine ;
- un alkylamine : $C_{12}H_{25}NH_2$ pour un composé comprenant une fonction amine.

Les particules sont déposées sur le substrat sous la forme d'une suspension colloïdale, en suspension dans l'eau pour les ligands comprenant une fonction phosphine ou citrate, en suspension dans le toluène pour les ligands comprenant une fonction amine.

La dimension des nanoparticules (21) est comprise entre $2.10^{-9}$ mètres ou nanomètres, et peut atteindre 1 $\mu$m de sorte que l'épaisseur de l'assemblée (20) de nanoparticules comprise entre les deux électrodes (31, 32) est comprise entre $2.10^{-9}$ et $100.10^{-6}$ mètres selon la dimension des nanoparticules et le nombre de couches déposées. Les nanoparticules sont par exemple des nanoparticules d'or.

L'ensemble comprenant la première électrode (31), l'assemblée de nanoparticules (20) et la seconde électrode (32), est avantageusement recouvert d'un film isolant (non représenté). Lorsqu'une force sensiblement normale à la surface de la seconde électrode (32) est appliquée à cet ensemble, celle-ci déplace les nanoparticules et modifie la distance entre celles-ci au sein de ladite assemblée. Dès lors qu'une propriété électrique est sensible à la distance entre lesdites nanoparticules, la mesure de cette propriété à l'aide de moyens appropriés (40) entre les deux électrodes, délivre une information proportionnelle à la déformation de l'assemblée de nanoparticules sous l'effet de la sollicitation. Selon cet exemple de réalisation ladite sollicitation est appliquée sur la seconde électrode de manière sensiblement normale à celle-ci. Le substrat (10) peut indifféremment être rigide ou souple, l'assemblée de nanoparticules constitue le corps d'épreuve de ce microcapteur (100). Un tel microcapteur peut avantageusement être utilisé pour mesurer des forces, ou toute autre grandeur physique de même nature. Par exemple, en disposant une micro-masse sur la seconde électrode il peut constituer un micro-accéléromètre.

Figure 2, afin de fonctionnaliser une surface tactile de dimension importante et de détecter sur cette surface les coordonnées du point d'application de l'effort, de tels microcapteurs (100) peuvent être combinés selon un arrangement matriciel. À cette fin, une pluralité de bandes conductrices (310 à 314) est déposée par tout procédé de dépôt connu sur un substrat isolant (10) et constitue la première électrode. Selon un exemple de réalisation, une couche isolante (50) est alors déposée, par tout procédé connu tel que la photolithographie, sur lesdites bandes conductrices (figure 2A). La couche isolante (50) est structurée avec des trous (51) répartis selon un pas transversal perpendiculaire à la direction d'extension des bandes conductrices (310 à 314) et égal au pas de dépose desdites bandes sur le substrat dans cette même direction.

Figure 2B, des amas de nanoparticules comprenant au moins deux couches superposées sont déposés dans les trous, en contact avec les bandes conductrices (310 à 314), par toute méthode connue telle que le dépôt convectif capillaire. Des secondes bandes conductrices (320 à 322) s'étendant selon une direction différente de celle des premières bandes conductrices déposées sur le substrat, sont déposées sur la surface de la couche isolante (50) de sorte que lesdites secondes bandes conductrices soient en contact avec les amas de nanoparticules (200) placés dans les trous (51) de la couche isolante structurée (50), et constituent la seconde électrode. Préférentiellement la direction de dépôt des secondes bandes conductrices (320 à 322) constituant la seconde électrode est perpendiculaire à la direction des premières bandes conductrices (310 à 314) déposées sur le substrat. Un film isolant (non représenté) vient avantageusement recouvrir le tout. Selon un mode de réalisation alternatif, la couche isolante comprenant un réseau de trous n'est pas déposée et les amas de nanoparticules sont déposés de manière structurée directement sur les bandes conductrices constituant la première électrode.

L'ensemble peut ensuite être déposé sur une surface afin de la fonctionnaliser et la rendre tactile. Alternativement le substrat peut constituer directement la surface fonctionnalisée.

Lorsqu'une pression, par exemple digitale ou par l'intermédiaire d'un stylet, est appliquée sur une surface ainsi rendue fonctionnelle, une zone plus ou moins importante de ladite surface est affectée par cette pression selon le mode d'application de celle-ci. La distance entre les nanoparticules des amas (200) se trouvant dans cette zone affectée est modifiée, modifiant ainsi une propriété électrique de couplage entre la première électrode, placée sur le substrat (10) et la seconde électrode placée sur la couche isolante (50) en contact avec les amas (200). Cette propriété électrique est par exemple la résistivité.

Ainsi, en mesurant la résistance entre la première et la seconde électrode en procédant par paire de bandes conductrices, il est possible, à l'aide d'un traitement approprié des mesures, de localiser le point d'application de la force résultante de la pression ainsi que l'intensité de ladite force. Par exemple, si la force est appliquée au centre de la surface ainsi rendue fonctionnelle, la résistance mesurée entre les bandes conductrices (312, 321) passant par le milieu de la surface sera plus affectée que la résistance mesurée entre les bandes conductrices (314, 322) s'étendant le long des bords de ladite surface.

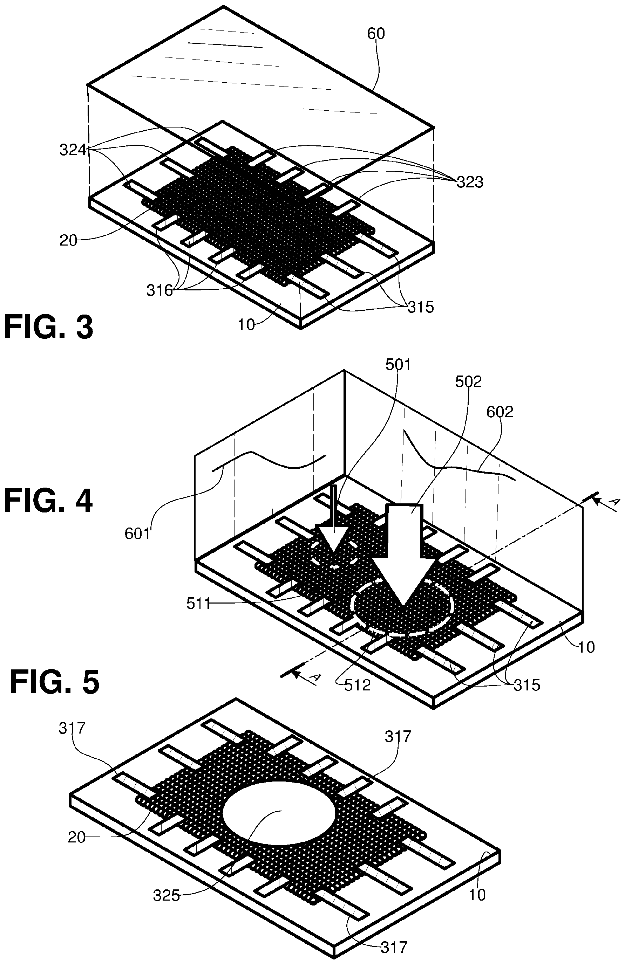

Figure 3, selon un deuxième mode de réalisation, le dispositif objet de l'invention comprend un substrat isolant (10), sur lequel est déposée une assemblée de nanoparticules (20) couvrant la majorité de la surface de celui-ci. Ladite assemblée de nanoparticules peut être monocouche ou comprendre plusieurs couches superposées selon une direction normale à la surface du substrat (10).

Un premier ensemble de bandes conductrices (315, 316) est déposé sur le substrat afin de constituer la première électrode, de sorte que lesdites bandes s'étendent entre une partie du substrat non couverte par l'assemblée de nanoparticules et ladite assemblée en contact avec celle-ci. Un second ensemble de bandes (323, 324), constituant la seconde électrode, est déposé de la même manière que les premières, en symétrie de celles-ci par rapport au centre de la surface de l'assemblée de nanoparticules. Finalement, un film isolant (60) est déposé sur le tout.

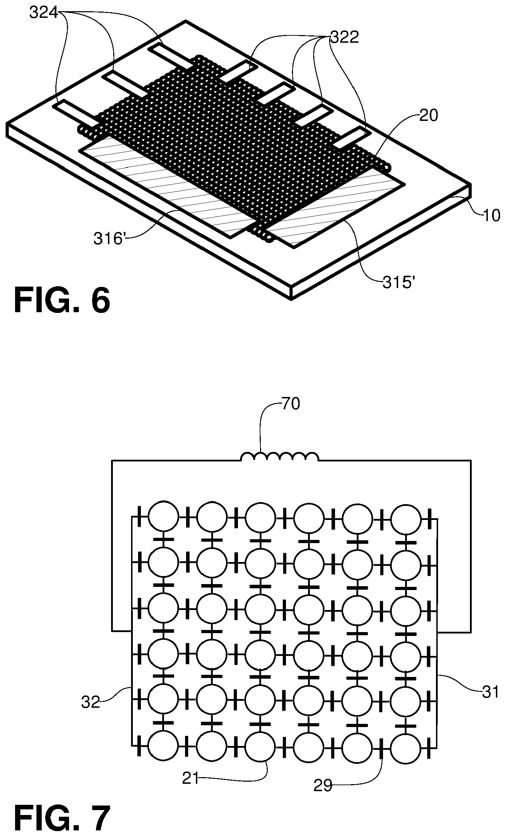

Figure 6, selon une variante de ce mode de réalisation, les bandes discrètes constituant la première électrode sont regroupées en une ou plusieurs bandes (315', 316').

Figure 4, lorsqu'un système de forces (501, 502), essentiellement normale à la surface ainsi fonctionnalisée est appliqué à ladite surface, celui-ci affecte des zones (511, 512) plus ou moins importantes de l'assemblée de nanoparticules. Dans ces zones affectées (511, 512), la distance entre les nanoparticules de l'assemblée est modifiée, de sorte que les propriétés électriques le sont également. En effectuant une ou plusieurs mesures d'une propriété électrique entre la première électrode (315, 316) et la seconde électrode (322, 324) et en procédant par paires de bandes conductrices, on obtient des profils (601, 602) donnant la variation de ladite propriété électrique en fonction de la direction joignant les deux bandes entre lesquelles la mesure a été réalisée. À partir de ces profils de variation, l'intensité des efforts (501, 502) ainsi que leur point d'application peuvent être déterminés par un traitement du signal approprié.

Figure 5, selon un troisième mode de réalisation, le dispositif objet de l'invention comprend un substrat isolant (10) sur lequel est déposée une assemblée de nanoparticules (20) recouvrant une partie de la surface dudit substrat. La première électrode est constituée d'un ensemble de bandes (317) déposée sur le substrat et s'étendant entre une partie non couverte du substrat et l'assemblée de nanoparticules (20), en contact avec celle-ci. La seconde électrode (325) est placée sur l'assemblée de nanoparticules, l'ensemble étant recouvert d'un film isolant (non représenté). Lorsqu'une force est appliquée sur la seconde électrode (325), tant les composantes normales que tangentielles de ladite force modifient la distance entre les nanoparticules de l'assemblée (20). Le point d'application de la force étant connu, c'est-à-dire sensiblement au centre de la seconde électrode (325), la mesure d'une propriété électrique entre ladite seconde électrode (325) et chacune des bandes (317) constituant la première électrode permet de déterminer, par un traitement du signal approprié, l'intensité et l'orientation de la force par rapport à l'assemblée de nanoparticules. Un microcapteur de force tridimensionnel est ainsi créé, qui peut être combiné en réseau matriciel afin de couvrir une surface ainsi fonctionnalisée plus importante.

Figure 7, la propriété électrique sensible à la distance entre les nanoparticules de l'assemblée est par exemple la résistivité électrique de ladite assemblée. La variation de cette propriété électrique avec la variation de distance entre les nanoparticules de l'assemblée est connue de l'art antérieur et a été attribuée à une variation de l'effet tunnel entre les nanoparticules, sans que la présente invention ne soit pour autant liée à une quelconque théorie. Selon un mode de réalisation alternatif du dispositif objet de l'invention il est possible de mesurer la variation de capacité de ladite assemblée. À cette fin, les nanoparticules conductrices (21) sont liées par un ligand approprié, choisi dans les composés décrits précédemment ou dans d'autres composés présentant une grande résistivité électrique et des propriétés de liaison chimiques similaires.

Chaque paire de nanoparticules séparée par ledit ligand constitue un nano-condensateur, dont la capacité (29) est notamment fonction de la distance entre les nanoparticules conductrices. Ainsi, de manière similaire, l'application d'un effort sur cette assemblée de nanoparticules, modifie la distance entre lesdites nanoparticules et la capacité électrique de ladite assemblée. Cette variation de capacité entre les électrodes (31, 32) peut être mesurée en intégrant la dite assemblée en série/parallèle dans un circuit électrique. Cette configuration offre la possibilité de pouvoir lire la mesure à distance au moyen de protocoles bien connus de l'art antérieur du domaine des radiofréquences. À cette fin, un circuit résonant est, par exemple, réalisé en couplant une inductance (70) en parallèle avec l'assemblée de nanoparticules.

Un tel circuit est défini notamment par sa fréquence de résonance ($f_0$), laquelle est donnée par la relation :

$$f_0 = \frac{1}{2\pi\sqrt{LC}}$$

où L est la valeur de l'inductance, fixe, et C la capacité de l'assemblée de nanoparticules, laquelle varie en fonction des sollicitations auxquelles est soumise ladite assemblée. Ainsi en mesurant la fréquence de résonance d'un tel circuit soumis à une excitation électromagnétique, il est possible de déterminer la variation de capacité de ladite assemblée.

Par exemple, le circuit est soumis à une excitation électromagnétique continue de fréquence $f_0$. Initialement le système absorbe énormément à cette fréquence.

La présence d'une déformation modifie le spectre d'absorption en le décalant vers les fréquences plus élevées ou plus basses par la modification de la capacité de l'assemblée. Le coefficient d'absorption à la fréquence $f_0$ s'en trouve changé.

Selon un autre mode de réalisation, le circuit est soumis à une excitation électromagnétique pulsée de fréquence $f_0$. Après chaque pulsation d'excitation, la mesure de l'émission du circuit pendant sa relaxation permet de mesurer son coefficient d'absorption et d'en déduire la capacité de l'assemblée de nanoparticules.

Pour sélectionner des mesures par paires de bandes conductrices, le dispositif peut être couplé à un composant contenant un code d'identification unique. Ce code binaire peut servir à activer ou non chaque circuit résonant compris entre une bande de la première électrode et une bande de la seconde électrode.

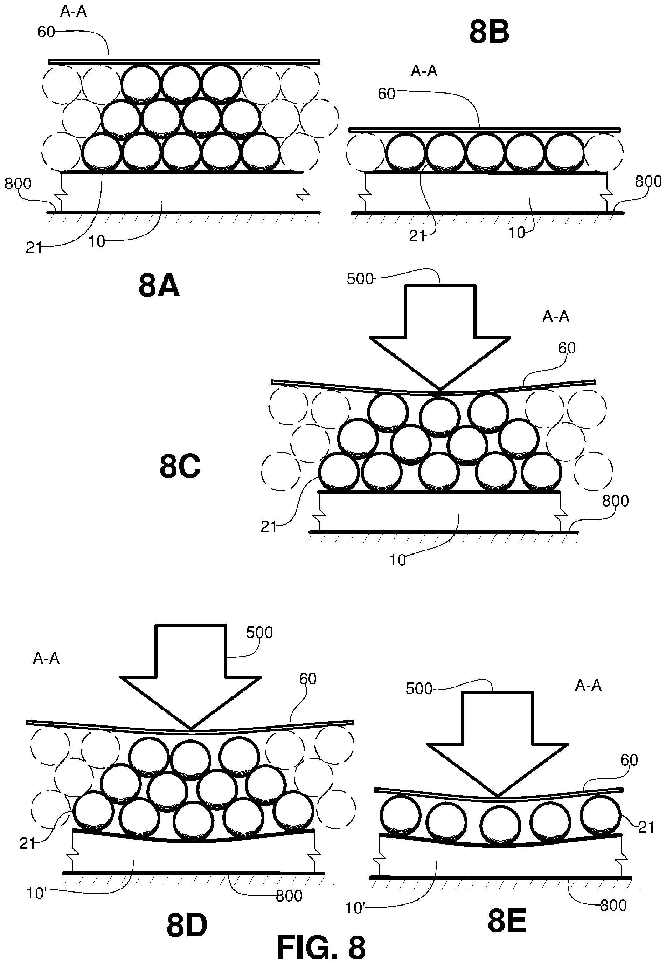

Figure 8, l'assemblée de nanoparticules déposée sur le substrat (10) peut être monocouche (figure 8B) ou comporter plusieurs couches superposées (figure 8A). L'ensemble peut à son tour être déposé ou collé sur la surface (800) à fonctionnaliser, laquelle, d'un point de vue pratique, est alors assimilée à la surface tactile compte tenu de la faible épaisseur du dispositif objet de l'invention. Figure 8C, en cas d'application d'une force (500) selon une direction normale au substrat (10) sur une assemblée de nanoparticules, la distance entre les nanoparticules d'une assemblée comprenant plusieurs couches superposées est modifiée à la fois dans une direction normale à la surface et dans des directions tangentielles à cette surface.

Figure 8E, dans le cas d'une assemblée monocouche, l'application d'une force (500) normale à la surface du substrat ne peut être détectée et mesurée que si celle-ci produit un déplacement des nanoparticules (21) tangentiellement à la surface dudit substrat. Ainsi, dans le cas d'une assemblée monocouche le substrat (10') est choisi de sorte qu'il présente une certaine compressibilité ou flexibilité superficielle, de sorte qu'un effort normal (500) provoque ce déplacement tangentiel des nanoparticules. L'assemblée de nanoparticules reste cependant le corps d'épreuve car c'est directement la déformation de cette assemblée qui est mesurée, la compressibilité du substrat n'étant qu'un facteur assimilable à un gain.

Figure 8D, un substrat superficiellement compressible peut également être utilisé avec une assemblée de nanoparticules constituée de plusieurs couches superposées.

La description ci-avant illustre clairement que par ses différentes caractéristiques et leurs avantages, la présente invention atteint les objectifs qu'elle visait. En particulier, elle permet de fonctionnaliser une surface tactile pour la rendre sensible à l'intensité et à l'orientation d'un système de forces sollicitant une telle surface.

## Revendications

1. Surface tactile comprenant une surface de mesure pour la détection et la quantification d'une force (500, 501, 502) appliquée sur ladite surface de mesure, laquelle force comprend une composante normale à ladite surface de mesure qui comporte une pluralité d'ensembles de nanoparticules, organisés selon un réseau matriciel, chaque ensemble de nanoparticules comprenant :

   - un substrat électriquement isolant (10) ;
   - une première électrode (31, 315, 316, 310, 311, 312, 313, 314, 315', 316', 317) liée au substrat et fixe par rapport audit substrat ;
   - une assemblée de nanoparticules (20, 200) conductrices ou semi-conductrices liées entre-elles par un ligand électriquement résistant apte à se lier chimiquement aux nanoparticules de ladite assemblée, laquelle assemblée est structurée et organisée en au moins deux couches selon une direction normale au substrat ;
   - un dispositif de mesure délivrant une information proportionnelle à une propriété électrique de l'assemblée de nanoparticules, laquelle propriété est proportionnelle à une variation de distance entre les nanoparticules (21) de l'assemblée (20, 200) et est mesurée entre la première électrode et une seconde électrode ;

   **caractérisée en ce que** :

   - la seconde électrode (32, 325, 320, 321, 322) est superposée à la première électrode selon une direction normale au substrat, l'assemblée de nanoparticules (20,200) se trouvant entre la première et la seconde électrode de telle sorte que l'application d'un effort sur la seconde électrode (32, 325, 320, 321, 322) sollicite directement l'assemblée de nanoparticules, selon une composante normale au substrat, et provoque une modification de la distance entre les nanoparticules (21) de ladite assemblée, l'assemblée de nanoparticules consituant ainsi elle même un corps d'épreuve.

2. Surface tactile selon la revendication 1, dans laquelle la propriété électrique est la résistance de l'assemblée de nanoparticules.

3. Surface tactile selon la revendication 1, dans laquelle la propriété électrique est la capacité électrique de l'assemblée de nanoparticules.

4. Surface tactile selon la revendication 1, dans laquelle :

   - la première électrode consiste en une pluralité de bandes conductrices parallèles (310, 311, 312, 313, 314) s'étendant sur la surface du substrat dans une première direction ;
   - la seconde électrode (320, 321, 322) consiste en une pluralité de bandes conductrices parallèles s'étendant dans un plan distant de et parallèle à la surface du substrat et dans une seconde direction différente de la première ;
   - les ensembles de nanoparticules (200) et se trouvant entre les deux électrodes aux emplacements de croisement des directions des bandes conductrices de la première et de la deuxième électrode.

5. Surface tactile selon la revendication 1, dans laquelle les ensembles de nanoparticules comprennent une première électrode (317) consistant en des bandes conductrices liées au substrat et s'étendant entre une partie de la surface dudit substrat non couverte par l'assemblée de nanoparticules et le pourtour de la surface couverte par les nanoparticules et une seconde électrode (325), sur l'assemblée de nanoparticules, mobile par rapport au substrat

6. Procédé pour la fabrication d'un dispositif selon la revendication 4, **caractérisé en ce qu'**il comprend les étapes consistant à :

   - déposer sur un substrat isolant (10) un premier réseau de bandes conductrices parallèles (310, 311, 312, 313, 314) s'étendant selon une première direction ;
   - déposer sur ces bandes des amas (200) de nanoparticules lesquels amas comprennent au moins deux couches de nanoparticules superposées dans une direction normale à la surface du substrat, les amas étant séparés les uns des autres et disposés selon un motif répétitif dans une direction parallèle à la direction des bandes (310, 311, 312, 313, 314) ;
   - déposer sur l'ensemble un second réseau de bandes conductrices parallèles (320, 321, 322) s'étendant selon une seconde direction différente de la première et contactant les amas (200) de nanoparticules.

7. Procédé selon la revendication 6, dans lequel l'étape de dépôt des amas (200) de nanoparticules selon un motif répétitif comprend des étapes consistant à :

   - déposer sur l'ensemble substrat (10) et premier réseau de bandes conductrices (310, 311, 312, 313, 314) une couche isolante (50) comprenant des trous (51) débouchant sur lesdites bandes ;
   - déposer dans les trous (51) de la couche isolante (50) des amas (200) de nanoparticules comprenant au moins deux couches superposées dans une direction sensiblement normale à la surface du substrat (10) et contactant les bandes conductrices (310, 311, 312, 313, 314) sous-jacentes ;
- déposer sur la couche isolante (50) le second réseau de bandes conductrices parallèles (320, 321, 322) s'étendant selon une seconde direction différente de la première et contactant les amas (200) de nanoparticules.

**Patentansprüche**

1. Taktile Fläche, die eine Messfläche für das Erkennen und das Quantifizieren einer Kraft (500, 501, 502) umfasst, welche auf die Messfläche angewendet wird, wobei die Kraft eine senkrechte Komponente zu der Messfläche umfasst, die eine Vielzahl von Nanopartikel-Baugruppen beinhaltet, welche gemäß einem matrixartigen Netz organisiert sind, wobei jede Nanopartikel-Baugruppe umfasst:

   - ein elektrisch isolierendes Substrat (10);
   - eine erste Elektrode (31, 315, 316, 310, 311, 312, 313, 314, 315', 316', 317), die mit dem Substrat verbunden und in Bezug auf das Substrat fest ist;
   - eine Ansammlung von leitenden oder halbleitenden Nanopartikeln (20, 200), die untereinander über einen elektrisch widerstandsbehafteten Liganden verbunden sind, welcher in der Lage ist, sich chemisch an die Nanopartikel der Ansammlung zu binden, wobei die Ansammlung in mindestens zwei Schichten gemäß einer zum Substrat senkrechten Richtung strukturiert und organisiert ist;
   - eine Messvorrichtung, welche eine Information liefert, die zu einer elektrischen Eigenschaft der Nanopartikelansammlung proportional ist, wobei die Eigenschaft zu einer Abstandsvariation zwischen den Nanopartikeln (21) der Ansammlung (20, 200) proportional ist und zwischen der ersten Elektrode und einer zweiten Elektrode gemessen wird;

   **dadurch gekennzeichnet, dass**:

   - die zweite Elektrode (32, 325, 320, 321, 322) der ersten Elektrode gemäß einer zum Substrat senkrechten Richtung überlagert ist, wobei sich die Nanopartikelansammlung (20, 200) zwischen der ersten und der zweiten Elektrode befindet, derart, dass das Anwenden einer Kraft auf die zweite Elektrode (32, 325, 320, 321, 322) die Nanopartikelansammlung direkt gemäß einer zum Substrat senkrechten Komponente belastet und eine Modifikation des Abstands zwischen den Nanopartikeln (21) der Ansammlung hervorruft, wobei die Nanopartikelanordnung somit selbst einen Beweiskörper darstellt.

2. Taktile Fläche nach Anspruch 1, wobei die elektrische Eigenschaft der Widerstand der Nanopartikelansammlung ist.

3. Taktile Fläche nach Anspruch 1, wobei die elektrische Eigenschaft die elektrische Kapazität der Nanopartikelansammlung ist.

4. Taktile Fläche nach Anspruch 1, wobei:

   - die erste Elektrode aus einer Vielzahl von parallelen leitenden Streifen (310, 311, 312, 313, 314) besteht, die sich auf der Fläche des Substrats in einer ersten Richtung erstrecken;
   - die zweite Elektrode (320, 321, 322) aus einer Vielzahl von parallelen leitenden Streifen besteht, die sich in einer Ebene, die zur Fläche des Substrats beabstandet und parallel ist, und in einer von der ersten Richtung verschiedenen zweiten Richtung erstrecken;
   - wobei die Nanopartikel-Baugruppen (200) zwischen den zwei Elektroden an den Kreuzungsstellen der Richtungen der leitenden Streifen der ersten und der zweiten Elektrode befinden.

5. Taktile Fläche nach Anspruch 1, wobei die Nanopartikel-Baugruppen eine erste Elektrode (317) umfassen, die aus leitenden Streifen besteht, welche mit dem Substrat verbunden sind und sich zwischen einem Teil der Fläche des Substrats, der nicht von der Nanopartikelansammlung bedeckt ist, und dem Umfang der Fläche erstrecken, der von den Nanopartikeln bedeckt ist, und eine zweite Elektrode (325) auf der Nanopartikelansammlung, die in Bezug auf das Substrat beweglich ist.

6. Verfahren für die Herstellung einer Vorrichtung nach Anspruch 4, **dadurch gekennzeichnet, dass** es die Schritte umfasst, die bestehen im:

   - Abscheiden eines ersten Netzes von parallelen leitenden Streifen (310, 311, 312, 313, 314) auf einem isolierenden Substrat (10), die sich gemäß einer ersten Richtung erstrecken;
   - Abscheiden von Nanopartikel-Clustern (200) auf diesen Streifen, wobei die Cluster mindestens zwei Nanopartikelschichten umfassen, die in einer zur Fläche des Substrats senkrechten Richtung überlagert sind, wobei die Cluster voneinander getrennt und gemäß einem Muster angeordnet sind, das sich in einer zur Richtung der Streifen (310, 311, 312, 313, 314) parallelen Richtung wiederholt;
   - Abscheiden eines zweiten Netzes von parallelen leitenden Streifen (320, 321, 322) auf der Baugruppe, die sich gemäß einer von der ersten verschiedenen zweiten Richtung erstrecken und die Nanopartikel-Cluster (200) berühren.

7. Verfahren nach Anspruch 6, wobei der Schritt des Abscheidens der Nanopartikel-Cluster (200) gemäß einem sich wiederholenden Muster Schritte umfasst, die bestehen im:

> - Abscheiden, auf der Baugruppe Substrat (10) und erstes Netz leitender Streifen (310, 311, 312, 313, 314), einer isolierenden Schicht (50), die Löcher (51) umfasst, welche auf den Streifen münden;
> - Abscheiden, in den Löchern (51) der isolierenden Schicht (50), von Nanopartikel-Clustern (200), welche mindestens zwei Schichten umfassen, die in einer im Wesentlichen zur Fläche des Substrats (10) senkrechten Richtung überlagert sind und die darunterliegenden leitenden Streifen (310, 311, 312, 313, 314) berühren;
> - Abscheiden, auf der isolierenden Schicht (50), des zweiten Netzes paralleler leitender Streifen (320, 321, 322), die sich gemäß einer von der ersten verschiedenen zweiten Richtung erstrecken und die Nanopartikel-Cluster (200) berühren.

**Claims**

1. Touch surface comprising a measurement surface for detection and quantification of a force (500, 501, 502) applied to said measurement surface, this force comprising a component normal to said measurement surface that comprises a plurality of sets of nanoparticles, organised in a matrix network, each set of nanoparticles comprising:

> - an electrically insulating substrate (10);
> - a first electrode (31, 315, 316, 310, 311, 312, 313, 314, 315', 316', 317) connected to the substrate and fixed relative to said substrate;
> - an assembly of conducting or semiconducting nanoparticles (20, 200) bonded to each other by an electrically resistant ligand capable of chemically bonding to the nanoparticles of said assembly, this assembly being structured and organised in at least two layers along a direction normal to the substrate;
> - a measurement device outputting information proportional to an electrical property of the assembly of nanoparticles, this property being proportional to a variation in the distance between the nanoparticles (21) in the assembly (20, 200) and being measured between the first electrode and the second electrode;

**characterised in that**:

> - the second electrode (32, 325, 320, 321, 322) is superimposed on the first electrode along a direction normal to the substrate, the assembly of nanoparticles (20, 200) being located between the first and the second electrode such that the application of a force on the second electrode (32, 325, 320, 321, 322) directly loads the assembly of nanoparticles according to a component normal to the substrate, and changes the distance between the nanoparticles (21) in said assembly, the assembly of nanoparticles thus forming itself a proof body.

2. Touch surface according to claim 1, in which the electrical property is the resistance of the assembly of nanoparticles.

3. Touch surface according to claim 1, in which the electrical property is the electrical capacitance of the assembly of nanoparticles.

4. Touch surface according to claim 1, in which:

> - the first electrode consists of a plurality of parallel conducting bands (310, 311, 312, 313, 314) extending over the surface of the substrate in a first direction;
> - the second electrode (320, 321, 322) consists of a plurality of parallel conducting bands extending in a plane at a distance from and parallel to the surface of the substrate, and in a second direction different from the first;
> - the nanoparticle assemblies (200) being located between the two electrodes at the intersection locations of the directions of the conducting bands of the first and the second electrodes.

5. Touch surface according to claim 1, in which the sets of nanoparticles comprise a first electrode (317) consisting of conducting bands bonded to the substrate and extending between a part of the surface of said substrate not covered by the assembly of nanoparticles and the periphery of the surface covered by the nanoparticles and a second electrode (325) on the assembly of nanoparticles, free to move relative to the substrate.

6. Method for the fabrication of a device according to claim 4, **characterised in that** it comprises the steps of:

> - depositing on an insulating substrate (10) a first network of parallel conducting bands (310, 311, 312, 313, 314) extending along a first direction;
> - depositing clusters (200) of nanoparticles on these bands, said clusters comprising at least two layers of superimposed nanoparticles in a direction normal to the surface of the substrate, the clusters being separated from each other and arranged according to a repetitive pattern along a direction parallel to the direction of the bands (310, 311, 312, 313, 314);
- depositing a second network of parallel conducting bands (320, 321, 322) on the assembly, extending along a second direction different from the first direction and contacting the clusters (200) of nanoparticles.

7. Method according to claim 6, in which the step of depositing clusters (200) of nanoparticles according to a repetitive pattern comprises the steps of:

- depositing onto the assembly of the substrate (10) and the first network of parallel conducting bands (310, 311, 312, 313, 314) an insulating layer (50) containing through holes (51) opening up on said bands;
- depositing clusters (200) of nanoparticles containing at least two layers superimposed along a direction substantially normal to the surface of the substrate (10) and contacting the subjacent conducting bands (310, 311, 312, 313, 314), in the holes (51) in the insulating layer (50);
- depositing on the insulating layer (50) the second network of parallel conducting bands (320, 321, 322) extending along a second direction different from the first direction and contacting the clusters (200) of nanoparticles.

**FIG. 1**

**2A**

**FIG.2**

**2B**

**FIG. 3**

**FIG. 4**

**FIG. 5**

**FIG. 6**

**FIG. 7**

EP 2 601 491 B1

FIG. 8

15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2008238882 A
- US 7116209 B
- WO 03018307 A
- US 2009278815 A